# EUROPEAN PATENT SPECIFICATION

(11) **EP 4 050 389 B1**
(45) Date of publication and mention of the grant of the patent: **24.09.2025**
(21) Application number: 22305206.9
(22) Date of filing: 24.02.2022
(51) Int. Cl.: G02B 6/12, G02B 6/42

(54) **APPARATUS FOR INTEGRATING AN ELECTRONIC INTEGRATED CIRCUIT AND A PHOTONIC INTEGRATED CIRCUIT**
VORRICHTUNG ZUR INTEGRATION EINER INTEGRIERTEN ELEKTRONISCHEN SCHALTUNG UND EINER INTEGRIERTEN PHOTONISCHEN SCHALTUNG
APPAREIL D'INTÉGRATION D'UN CIRCUIT INTÉGRÉ ÉLECTRONIQUE ET D'UN CIRCUIT INTÉGRÉ PHOTONIQUE

(30) Priority: 26.02.2021 EP 21305230
(43) Date of publication of application: 31.08.2022
(73) Proprietor: Nokia Solutions and Networks Oy, 02610 Espoo (FI)
(72) Inventor: ENRIGHT, Ryan, New-York 11001 (US); SHEN, Alexandre, 91400 ORSAY (FR)
(74) Representative: Novagraaf Technologies

(56) References cited:
- WO-A1-2020/225578
- US-A- 6 094 919
- US-A1- 2016 291 269
- US-B2- 10 234 646
- US-B2- 9 874 688
- PLOSZL A ET AL: "Silicon-on-insulator: materials aspects and applications", SOLID STATE ELECTRONICS, ELSEVIER SCIENCE PUBLISHERS, BARKING, GB, vol. 44, no. 5, 1 May 2000 (2000-05-01), pages 775 - 782, XP004191708, ISSN: 0038-1101, DOI: 10.1016/S0038-1101(99)00273-7

## Description

### TECHNICAL FIELD

Various example embodiments relate to embodiments of an apparatus for integrating electronic integrated circuits, hereafter abbreviated by EIC and a photonic integrated circuit, hereafter abbreviated by PIC. More particularly, various embodiments relate to EIC-INTEGRATED PICs enabling effective thermal management temperature control and heat removal.

### BACKGROUND

As known by those skilled in the art, Silicon (Si) photonics is currently an active area of research and has begun to be commercialized due to the advantages of using Si/SiO₂ or Si/SiN for passive photonic components to achieve, for example, low loss waveguides and compact arrayed waveguides, the potential for tighter integration with Si-based electronics, as well as a significant processing infrastructure built up by investment in complementary metal oxide semiconductor (CMOS) technology. Arguing economies of scale, this last point-the potential of leveraging CMOS technology - offers promise for reducing the cost of silicon-based photonic integrated circuits (PIC) in comparison to their monolithic III-V material counterparts. However, this level of integration also poses significant challenges due to the very different thermal profiles associated with photonics and electronics. In addition, since Si is an indirect bandgap material, an integrated light source that performs well under the required conditions has remained elusive. This has led to the development of heterogeneously integrated laser devices such as III-V/Si hybrid evanescent lasers, where discrete III-V material active photonic devices are placed on a silicon-on-insulator (SOI) substrate¹. From a thermal perspective, silicon photonics is challenging for several reasons. The fact that the architecture is essentially junction-side-up makes it difficult to remove the heat load; the poor thermal properties of the typical oxide isolation layer on SOI wafers separate the device from the heat sink; and the ridge-like geometry of waveguides in the active device increases the thermal spreading resistance. Further, the distinctly different absolute temperatures and temperature control requirements for photonic and electronic devices present challenges as we move towards opto-electronic integration.

Thermal management has typically been relegated to the last step in the design process and traditionally considered only to ensure long-term operation of the electronic and photonic devices. Today, thermal management represents one of the biggest bottlenecks to releasing next-generation equipment across the entire network and at every scale from the nano (transistor/photonic active region) to the macro (datacenter/telecom network).

Heterogeneous III-V/Si DFB and tunable lasers have risen in maturity over the last ten years. However, while some stand-alone transmitter products do exist (Intel, Luxtera/Cisco, etc.), and have found use as external laser sources for photonic engines (Acacia/Cisco), their full integration in a complex PIC is far from widespread. Indeed, packaging has been identified as a major hurdle towards leveraging the low-cost potential of silicon photonics and is hindering the technology's potential in short-reach interconnects against competitive platforms. Most silicon photonic transmitter products implement complicated laser subassemblies that dominate the cost of the transceiver. A notable exception is Intel's hybrid silicon lasers for CWDM applications, a technology that brought Intel to the second place of silicon photonic transceiver manufacturers.

It is known by those skilled in the art, that, in terms of energy efficiency and energy proportionality, that on chip sources provide a dramatic overall system efficiency improvement, as compared to using an off-chip (comb) source. However, realizing this architecture for high bandwidth applications with low-cost photonic/electronic co-packaging approaches is complicated by the thermal requirements of active III-V photonic components. This has led the industry to take optical sources out of the package despite the fundamental limits this may impose on overall system efficiency. The primary issues that can be identified are wavelength stability for high bandwidth applications where channel spacings are small relative to temperature-induced wavelength shifts, laser/SOA junction refrigeration relative to the ambient temperature to ensure device reliability and the difficulty of integrating solid-state cooling using traditional telecom-grade thermoelectric coolers.

Following the ramp-up and commercial success of 100G pluggable modules after 2016, the industry is now focusing on the next evolutionary step. As several end-users are set to skip the "intermediate" 200G generation, 400G is in the spotlight. As manifested at the latest OFC, most vendors are already showcasing or offering 400G products with the main focus on 4-lane DR4 and FR4 variants, for short reach PAM4 (500 m and 2 km respectively), and ZR for 120km single-lane coherent (≤15 W for ZR400). The availability of 7nm DSP will reduce the power dissipation of short-reach 400G IM/DD transceivers to 8 W and will bring their coherent counterparts to ~14W. Latest announcements at OFC also confirm the possibility for 800G modules with 14W power consumption that fits within the power envelope of OSFP/QSFP-DD pluggable modules. Research is also starting to address 800G leveraging existing components (53 Gbaud for IM/DD, 64 Gbaud for coherent) with more advanced modulation and signal processing. The necessity for higher bandwidth electro-optic components is identified to overcome power, reach and latency constraints of such approaches and preliminary efforts are targeting towards 100 Gbaud components.

In parallel to conventional transceiver form factors, datacenter switch vendors are transitioning to a new packaging paradigm for their high-capacity products. The ubiquitous front-panel pluggable concept is reaching its limits and it is expected that 800 Gb/s pluggable modules will mark the last generation of the technology. By packing 32 pluggable modules on the front panel of a 1U switch it will be possible to reach 25.6 Tb/s. In order to continue scaling switch bandwidth, switch vendors are aiming to bring the optics closer to the switch ASIC, following the multi-chip module approach. Preliminary demonstrations of co-packaged switches were recently reported by e.g. Intel, Ayar Labs and Rockley. Co-packaging has the potential for significant power savings at the overall system scale, however it also exacerbates current challenges in transceiver packaging, with the most pronounced one being heat dissipation.

Nowadays, market-available EIC-integrated PICs do not contain any lasers or light amplifiers, because of their temperature sensitivity. Their architecture is generally not energy efficient Moreover, any active photonic component, e.g., laser source, or passive photonic component, e.g., phase section, that sits on top of the Si-PIC will be affected by temperature in their operation. The distance of these components from the heat generating EIC(s) is sufficient to avoid excess heating. This leads to a necessary bigger footprint of the entire PIC chipset to mitigate thermal crosstalk associated with the thermal conductance of the PIC substrate material.

Therefore, most transceivers (TRx) contain two distinct packaged subsystems: one for the photonic modulation engine, and one for the optical source and amplification.

The American application US 2016/291269 discloses an apparatus integrating two photonic-integrated circuits, notably comprising a first component chip including a buried waveguide, the first component chip extending upwardly beyond a cavity formed in the substrate (that may be made of silicon on glass) of a second component chip. A separate covering lid is placed over the first component chip forming a cavity. A heat spreader made of a thermally conductive material is provided in the cavity in contact with the lid and the first component chip. In this apparatus, there is no targeted cooling of the photonic components.

In order to achieve highly integrated optoelectronics on a silicon photonics platform, silicon photonics is being pursued due to the integration cost-savings potential it offers for high bandwidth optoelectronic systems.

However, high-density integration of photonic and electronic components at the wafer level leads to thermal issues due to the use of:
- precise temperature control of photonic components, e.g., phase sections, lasers operating w/in tight channel spacings,
- active photonic refrigeration relative to the ambient temperature for reliability and optical performance reasons,
- Mitigating parasitic heat loads from non-temperature-controlled components, e.g. electronics that make control harder and more energy expensive.

In addition, there is the interest for a low-cost packaging paradigm at the wafer level that reduces cost while providing protection from the ambient, e.g., avoid using expensive goldbox packaging approaches.

Thus, in light of the foregoing, there is growing interest in a smart thermal management solution allowing the integration of the lasers and amplifiers on the modulation photonic engine chipset, thus simplifying the transceiver architecture and decreasing its fabrication costs.

### SUMMARY

Various embodiments provide apparatuses and method to remedy some or all the disadvantages of the above identified prior art.

The embodiments and features described in this specification which, if any, would fall outside the scope of the independent claims are to be interpreted as useful examples for understanding the various embodiments.

A general embodiment relates to an apparatus according to claim 1.

By SOG, it is meant, in the sense of the application, a substrate made of silicon on glass, or a substrate made of any other suitable optical waveguide material (such as SiN, InP, LiNbO₃, etc.) on glass.

The apparatus of the general embodiment presents the following advantages:
- good electrical RF performance for routing and interfacing of high signal frequencies (~10 - 100 GHz),
- compact optical routing and interfacing
- efficient (sub-ambient to supra-ambient) temperature control and heat removal, and
- hermetic sealing of heat sensitive components.

By ambient temperature, it is meant in the sense of the present application the ultimate heat rejection temperature for the overall thermal management system.

Advantageously, the lid may be bonded to the substrate by a heat-free bonding mechanism.

By heat-free bonding mechanism, it is meant in the present application a bonding mechanism that does not involve a global heat treatment or a conductive material near the crossing the lid bond line. However, a localized *"high temperature"* heat treatment can be allowed, e.g., laser welding of the bond line.

By global heat treatment, it is meant in the sense of the application a heat treatment that is realized at a temperature exceeding the temperature allowable by the components assembled underneath the lid.

In particular, the lid may be bonded to the substrate by means of an adhesive (for instance an epoxy adhesive), or by means of an eutectic alloy bonding (i.e. metal bonding with a low thermal resistance), or by means of a hydrophilic bond obtained by direct wafer bonding of the lid to the substrate, or by means of silica interface obtained by laser welding of the lid to the substrate.

Advantageously, the first and/or third thermal interface(s) (TIM) may be selected from among gap pad filler materials, thermal greases, phase-change materials, graphite/carbon-backside materials. More generally, the thermal interface(s) (TIM) may be made of any suitable material commonly used for thermal interfacing.

For example, the at least one component from the Electronic Integrated Circuit (EIC) used in the present application may include in particular high-power transistors which are heat generators. The EIC can be flip chipped on top of the SOG.

In addition, the at least one active photonic device of the photonic-integrated circuit (PIC) used in the present application may include lasers, semiconductors, optical amplifiers (SOAs), modulators.

Preferably, the upper surface of the top wall of the lid may be provided with an array of heat-dissipating fins covering the at least one heat generating component.

According to a first variant, said array of heat-dissipating fins (64) may cover both the active photonic device and the electric or electronic component from the Electronic Integrated Circuit (EIC).

According to a second variant, the array of heat-dissipating fins may cover the electric or electronic component from the Electronic Integrated Circuit (EIC), while a second micro-thermoelectric module (µTEM) for temperature controlling the active photonic device may be present on the upper surface of the top wall of the lid above the active photonic device.

Preferably, for these two variants, the apparatus may further comprise two arrays of thermally conductive vias traversing the lid for mitigating parasitic heat from the non-temperature-controlled components of the Electronic Integrated Circuit (EIC) and from the components of the photonic-integrated circuit (PIC).

Preferably, the lid of the apparatus according to this alternative embodiment (including any of the two above-mentioned variants) may be made of silicon, metal or ceramic.

Preferably, the electrical inputs/outputs of the apparatus according to this alternative embodiment (including any of the two above-mentioned variants) may be comprised in an electrical I/O plane formed on said regrown layer of silica and linked to the Electronic Integrated Circuit.

Embodiments further provide a method according to claim 11.

Advantageously, wherein the bonding of the lidding wafer on the substrate may be realized by means of an adhesive, or by means of an eutectic alloy bonding, or by means of a hydrophilic bond obtained by direct wafer bonding of the lid to the substrate, or by means of silica interface obtained by laser welding of the lid to the substrate.

### BRIEF DESCRIPTION OF THE DRAWINGS

Some example embodiments are now described, by way of example only, and with reference to the accompanying drawings in which:
- FIG. 1 schematically represents a prior art apparatus;
- FIGs. 2a and 2b schematically represent two views of the apparatus according to the general embodiment, comprising a sectional view (FIG. 2a) and a transverse view according to the A-A' plane of the surface of the SOG silicon layer (FIG. 2b);
- FIG. 3 is a sectional view of a specific apparatus, not falling within the subject-matter for which protection is sought;
- FIG. 4 is a sectional view of a specific apparatus, not falling within the subject-matter for which protection is sought;
- FIG. 5 is a sectional view of variant of the specific apparatus of figure 4, not falling within the subject-matter for which protection is sought;
- FIG. 6 is a sectional view of a specific embodiment of the apparatus;
- FIG. 7 is a detailed sectional view of the specific embodiment of the apparatus shown in FIG. 6;
- FIG. 8 is a sectional view of an advantageous variant of the specific embodiment of the apparatus;
- FIG. 9 is a sectional view of another specific embodiment of the apparatus;
- FIG. 10 illustrates the different steps of the process flow for fabricating an apparatus according to the general embodiment.
- FIG. 11 shows 3D simulation results summary of a modelled assembly platform according to the specific apparatus shown in FIG. 3.

The same reference number represents the same element or the same type of element on all drawings, unless stated otherwise.

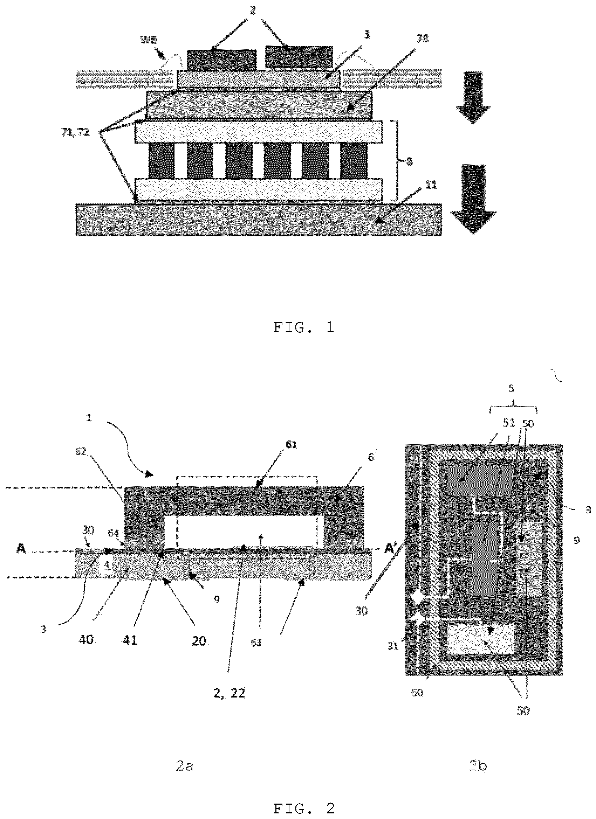

FIGs. 1 to 7 are described in more detail in the description which follows, given by way of indication. FIG. 1 schematically represents the apparatus according to the prior art, whereas figures 2 to 10 illustrate various example embodiments of the apparatus and the process flow for fabricating an apparatus according to the general embodiment, but without limiting the scope thereof.

### DETAILLED DESCRIPTION

Various example embodiments will now be described more fully with reference to the accompanying drawings in which some example embodiments are illustrated. In the figures, the thicknesses of lines, layers or regions may be exaggerated for clarity.

Accordingly, while example embodiments are capable of various modifications and alternative forms, embodiments thereof are shown by way of example in the figures and will herein be described in detail. It should be understood, however, that there is no intent to limit example embodiments to the particular forms disclosed, but on the contrary, example embodiments are to cover all modifications, equivalents, and alternatives falling within the scope of the claims.

Like numbers refer to like or similar elements throughout the description of the figures.

In the following description of the figures, schematic representations are non-limiting and serve only for the understanding.

Figure 1 shows a co-integrated EIC 2 and PIC 3 optoelectronic system according to the prior art requiring thermoelectric cooling, in which a cooler 8 takes out the heat generated by EICs, which flows across the PIC 3 and a heat spreader 78 (the heat being represented by a first arrow downward from the PIC 3 to the heat spreader 78) before being pumped out to a heat sink 11 positioned at the lowest level (the heat being then represented by a second arrow downward from the cooler 8 to the heat sink 11). Thus, this architecture is not energy efficient.

FIGs. 2a and 2b schematically represent two views of the apparatus according to the general embodiment comprising:
- a substrate 4 made of silicon (or any other suitable optical waveguide material (such as SiN, InP, LiNbO₃, etc.) on a glass (SOG), which comprises integrated electrical inputs/outputs 20 and optical inputs/outputs 30 and passive optical components 31 (fig. 2b) of the photonic-integrated circuit (PIC) 3 (fig. 2b) being formed in the silicon of the SOG, where the electrical inputs/outputs 20 form an electrical I/O plane that is located beneath the substrate 40 and connected to the outside by metal Through-Glass-Vias 9 traversing the substrate 4. On the substrate an interconnection layer is present for electrically connecting the components of the apparatus,this interconnection layer usually being a metallic interconnection layer.
- a plurality of heat generating components 5 from the Electronic Integrated Circuit (EIC) 2 (see FIG. 2a) and from the photonic-integrated circuit (PIC) 3 (see FIG. 2b),
- a lid 6 comprising a top wall 61 (with a lower surface and an upper surface) forming a thermal plane for a heatsink attachment and a side wall 62 being in contact with the substrate 4 and thus forming a lid bond line 60 on said substrate 4, this lid 6 defining a lidded cavity 63 comprised between the top wall (61), the side wall (62) and the substrate (4), said lid (6) being present on the substrate (4) such that the optical inputs/outputs of the photonic-integrated circuit (PIC) 3 and the electrical inputs/outputs are outside the lidded cavity 63 and said at least one heat generating component (5) is encapsulated within the lidded cavity 63.

The substrate 4 is made of silicon on a glass (SOG) (as shown in FIGs. 2 to 5). Similar to silicon-on-insulator (SOI) substrates, a SOG substrate provides the necessary device-grade silicon layer to form very compact optical waveguides/optical distribution layer 30 (ODL) (as indicated by the dashed white lines in FIG. 2b) and passive optical components 31, e.g., vertical coupling grating (see FIG. 2b) and/or edge coupling locations, that can be defined lithographically at wafer scale. In contrast to SOI, an SOG substrate is preferred because:
- glass has superior radio frequency (or RF) characteristics that allow significantly lower loss at high operating frequencies for the electrical distribution layers 20 (EDL), and
- glass is an excellent thermal insulator that allows to isolate heat generating components from each other when arranged compactly on the substrate, and to manage the removal of heat generated by components and the way temperature sensitive components are controlled (e.g. lasers, semiconductor optical amplifiers.

The lid 6 is used for extracting the heat generated by the heat generating components 5, 51, 52. The lid 6 provides a well-defined "thermal plane" for heatsink attachment and has the additional functionality of encapsulating the heat-generating components 5, 50, 51. In order to provide (semi)hermeticity with respect to the outer environment and ensure good light propagation to/from the optical I/O, the details of the lid bond 60 to the substrate (FIGs 2a and 2b) are carefully considered. First, the bonding mechanism should not involve a high temperature step to ensure the viability of the components 5, 50, 51 being encapsulated by the lid 6. Second, the bonding mechanism does not involve a conductive material near the waveguide crossing the bond line to avoid optical losses. If an adhesive, such as an epoxy, is used, the optical properties ensure confinement of the optical mode in the silicon waveguide, i.e., the adhesive refractive index is smaller than that of silicon. In addition, if the lid 6 is silicon, metallic or some other material with unsuitable conductivity and or refractive index, the bond line thickness is sufficient thick to ensure the optical mode does not become couped to the lid and incur losses. Additional bonding mechanisms include:
- direct wafer bonding of the lid 6 to the SOG substrate 4, i.e., hydrophilic bond, where the lid bond line is silica and sufficiently thick (~>1 µm) if the main material of the lid is silicon: This approach can be combined with a range of lid materials, provided silica can be deposited the necessary thickness on the lid bond line;
- laser welding of the lid 6 to the SOG substrate 4: with this mechanism, the optical transmissivity of the SOG substrate 4 and the thinness of the silicon device layer are exploited to focus a laser beam at the bond line interface to weld a silica interface.

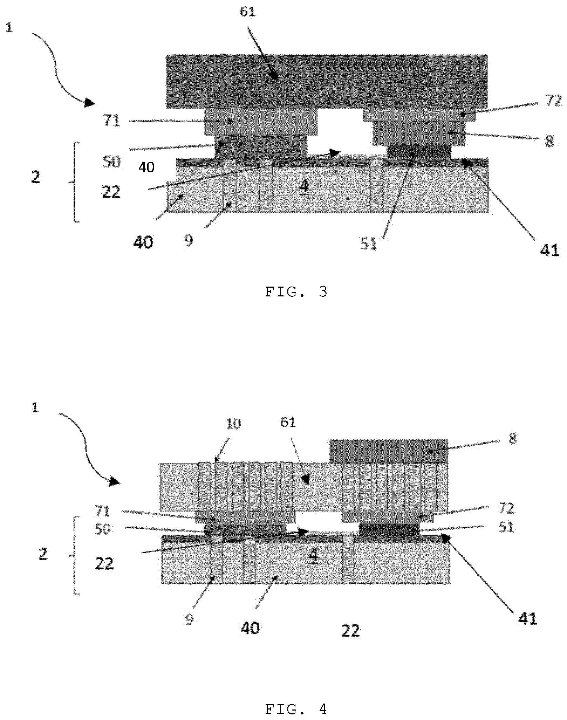

Figures 3 to 9 illustrate more particularly how the heat-generating components 5, 50, 51 within the lid cavity 63 are thermally interfaced to the lid 6: a thermal interface material (TIM) is required to thermally couple the heat generating components 5, 50, 51 to the lid 6. The TIM can be chosen based on the specific requirements of the component to be cooled and the level of compliance required. Thus, the TIM may be a gap pad filler material, a thermal grease, a phase-change material, a graphite/carbon-based material or any suitable material commonly used for thermal interfacing. The TIM may be applied to the backside of the component or to the lower surface of the top wall of the lid, depending on the type of heat-generating component 5, 50, 51. Of central importance is accommodating the differing thermal requirements between the electronics and photonics components.

If it concerns heat-generating components 50 from the Electronic Integrated Circuit (EIC) such as flip-chipped electronics and thermoelectric devices, then the maximum operating junction temperature for an electronics chip is typically higher than 85°C. Then the heat-generating components 50 are thermally interfaced to the lid 6 by a first thermal interface (TIM) 71 being both in contact with, on the one hand, the surface of the at least one heat generating component 50 which is opposite the substrate 4 and, on the other hand, in contact with the lower surface of the top wall 61 of said lid 6 (FIGs 3 to 5).

If it concerns heat-generating components 51 from of the photonic-integrated circuit (PIC) such as lasers and optical amplifiers (SOAs) (that may be formed on the SOG substrate via die bonding, etching and/or re-growth as it typical in standard SOI-based silicon photonics), or semiconductors, modulators, the maximum operating junction temperature can be as low as 40 °C (notably for lasers and SOAs) which is below typical application-dependent standards defined ambient temperatures (usually comprised between 45°C and 70 °C). Generally, this requires the use of a thermoelectric module (TEM) to ensure reliable operation of the photonics devices. However, cooling the entire assembly 1 comprised of both temperature sensitive photonic components 51 and temperature insensitive electronic components 50 with a single, large TEM results in unacceptably large energy consumption due to the characteristically low operating efficiency of thermoelectric modules. It is preferred to provide targeted cooling to only the devices requiring low temperature operation.

Thus, at least one micro-thermoelectric module (µTEM) 8, 82 is arranged in the assembly to control the temperature (notably to cool) the component according two alternative configurations and one variant.

FIG. 3 shows a first configuration not falling within the subject-matter for which protection is sought, wherein the lid 6 is entirely made of silicon and a micro-thermoelectric module(µTEM) 8 is positioned on the surface of the active photonic device 51 which is opposite the substrate 4. A thermal interface (TIM) 72 is arranged in the apparatus 1 so as to be both in contact, on the one hand, with the surface of the micro-thermal electric module (µTEM) 8 which is opposite to the active photonic device (51) and, on the other hand, in contact with the lower surface of the top wall 61 of said lid 6. Thus, the hot side of the µTEM 8 is interfaced to the lid 6 via the TIM 72. The apparatus shown in figure 3 further comprises metal Through-Glass-Vias 9 traversing the substrate 4 for electrically connecting the components of the apparatus from each other and to the outside.

In Figure 3, the electrical I/O plane20 located beneath the substrate 40 is not shown.

FIG. 4 shows a second configuration not falling within the subject-matter for which protection is sought, that differs from the first one (shown in FIG. 3) in that the lid 6 is entirely made of glass or ceramic, the micro-thermoelectric module (µTEM) 8 is positioned on the upper surface of the top wall 61 of the lid 6, and the apparatus 1 further comprises two arrays of thermally conductive vias 10 (located inside the lidded cavity 6) traversing the lid 6 for mitigating parasitic heat loads generated by the non-temperature-controlled components of the Electronic Integrated Circuit (EIC) 50 and by the components of the photonic-integrated circuit (PIC) (51), thus insulating the active photonic device 51 from the EICS. In Figure 4, the electrical I/O plane 20 located beneath the substrate 40 is not shown.

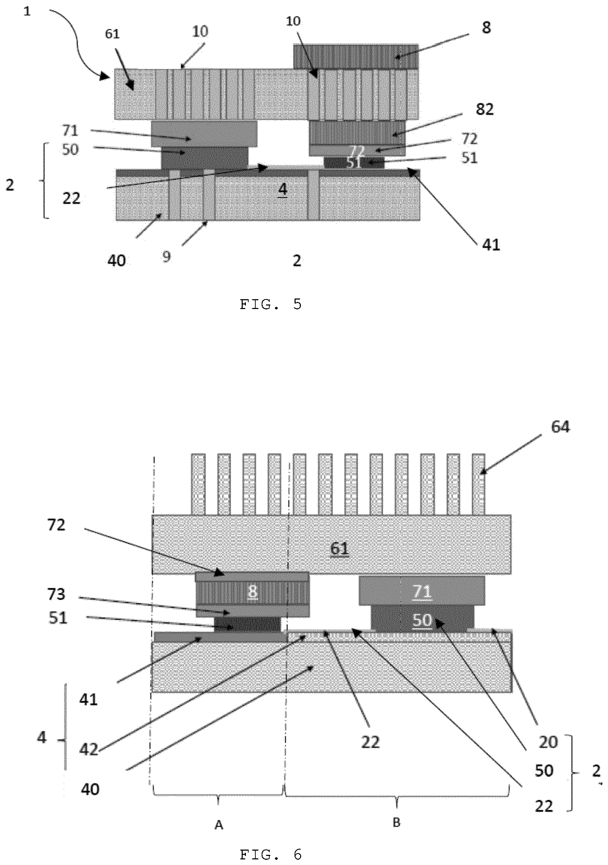

FIG. 5 shows a variant of this second configuration not falling within the subject-matter for which protection is sought, which further comprises a second micro-thermoelectric module (µTEM) 82 for cooling said active photonic device 51, said second micro-thermoelectric module (µTEM) 82 being positioned between the thermal interface (TIM) (72) and the lower surface of the top wall 61 of said lid 6. In Figure 5, the electrical I/O plane 20 located beneath the substrate 40 is not shown.

SOG with TGV are technologically difficult to be fabricated, especially when one needs to wafer-bond III-V dies on top of the TGV-SOG, because a special glass (with similar thermal dilatation coefficient as the Ill-V material) must be used for effective III-V bonding and III-V back-end processing. So TGV-free SOG shows a certain advantages as compared to TGV-SOG.

Thus, FIG. 6 shows a third configuration that differs from the first one (shown in FIG. 3) in that:
- it comprises a second thermal interface (TIM) 73 that is both in contact with the micro-thermoelectric module (µTEM) 8 and the active photonic device 51, so as to insulate the electrical contacts of the active photonic device 51 and the electrical contacts of the thermal electric module (TEM) and yet to ensure maximal thermal conductivity between both devices,
- the upper surface of the top wall 61 of the lid 6 is provided with an array of heat-dissipating fins 64 covering both the active photonic device 51 and the electric or electronic component 50 from the Electronic Integrated Circuit (EIC);
- within a predefined zone B of the substrate 4 located inside the lid bond line 50 and beneath the electrical inputs/outputs 20 and the electrical line 22, the thin layer of silicon 41 is etched and replaced by a regrown layer of silica 42, the remaining zone A inside the lid bond line 60 (the silicon waveguide is not indicated on Fig. 6) being positioned at least beneath the active photonic device 51, and

The electrical inputs/outputs 20 form an electrical I/O plane that is not located beneath the substrate 40 but on the regrown layer of silica 42, so as to be linked to the heat generating component (50) of the Electronic Integrated circuit.

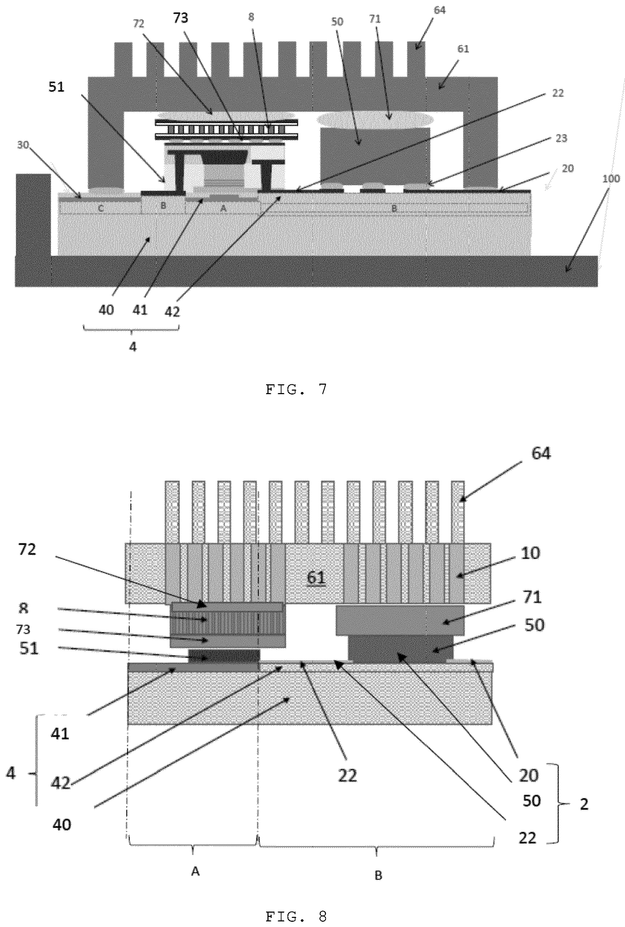

FIG. 7 is a detailed sectional view of the third specific embodiment of the apparatus shown in FIG. 6 (which is a schematic first-level mapping of figure 7). In the embodiment shown in figure 7, the active photonic device 51 can be either a InP-based phase section or a directly modulated laser gain section, or an electro-absorption modulator, being an element of a larger photonic subsystem such as a III-V/Si hybrid MZ-based modulator. This phase section 51 has to be driven by a driver (which is an element of the EIC 50. Thus there are RF lines 22 linking the phase section electrodes to the EIC 50.

The micro-thermoelectric module 8 is a thermo Electric Cooler (TEC) positioned on a TEC circuit (not shown in FIG. 7).

Solder bumps 23 are located between the substrate 4 (in particular the regrown layer 42 within zone B) and the EIC 50, for mechanical attachment of the EIC 50 on the substrate.

Within zone A, a subzone C might B formed, where the Si layer 41 comprises passive waveguides which transport optical signal in the PIC. This subzone C can be located beneath the lid walls 62 and also on either side of the walls 62, so as to transport optical signal to the optical couplers (optical I/O, 30 in fig. 2a) which are located outside the lid (6).

The whole apparatus 1 is integrated in a packaging module and mechanical support platform 100.

FIG.8 shows a variant of this third configuration (shown in FIGs. 6 and 7), which further comprises two arrays of thermally conductive vias 10 traversing the lid 6 for mitigating parasitic heat loads generated by the non-temperature-controlled components of the Electronic Integrated Circuit (EIC) 50 and by the components of the photonic-integrated circuit (PIC) 51, to ensure better thermal conduction through the top of the lid.

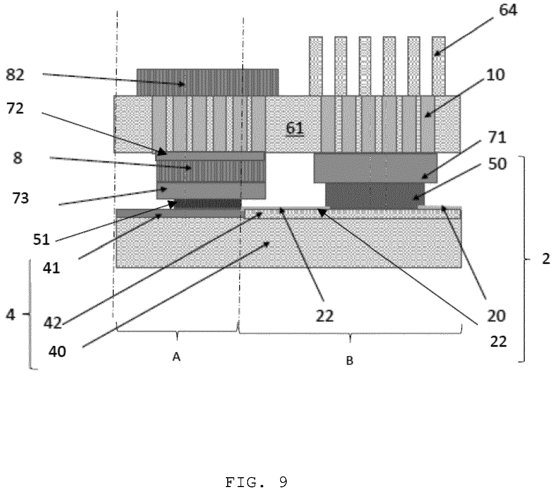

FIG.9 shows a fourth configuration that differs from the variant of the third configuration (shown in FIG. 8) in that the heat dissipating fins 64 above the active photonic device 51 are replaced by a second micro-thermoelectric module (µTEM) 82 for temperature controlling the active photonic device 51, said second micro-thermoelectric module (µTEM) 82 being located on the upper surface of the top wall 61 of the lid 6 above the active photonic device 51, so as to improve the heat dissipation thereby enhancing the efficiency of the phase tuning part of the PIC.

Thus, for all these configurations using a SOG 4 substrate, the thermal load of the TEM can be limited only to the target devices to be cooled, e.g. laser/SOA, laser/SOA array, modulators.

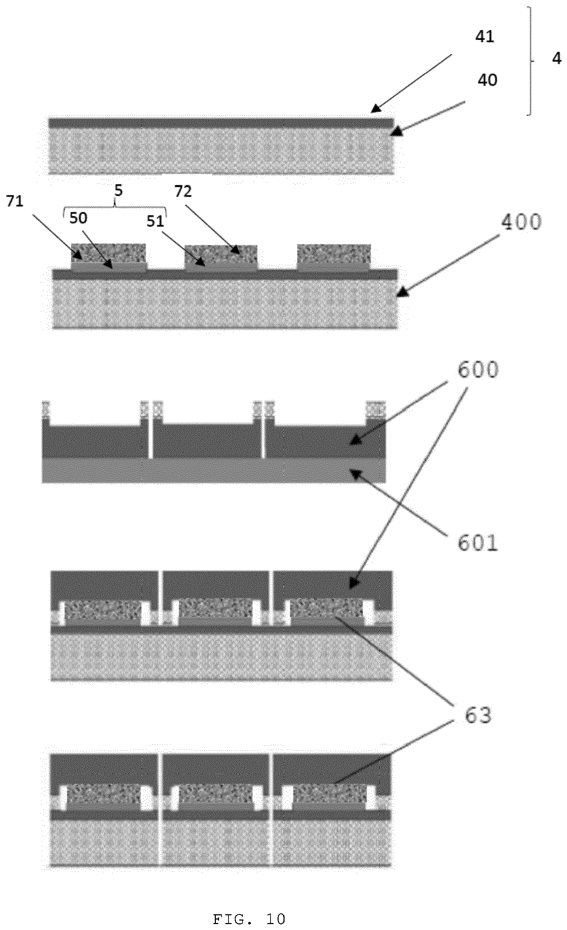

Figure 10 depicts the process flow to realize an apparatus according to the general embodiment as illustrated in figure 2. In particular, Figure 10 illustrates the process flow that comprises:
- providing a substrate 4 made of silicon on a glass (SOG) and forming the passive optical components 31 (notably Si waveguide/passives and III/V material wafer bonding and III/V material processing) of the photonic-integrated circuit (PIC) 3 in the silicon of the SOG (Fig. 9), wherein the substrate 4 comprises a layer of glass 40 on which is positioned a thin layer of silicon 41;
- depositing on the substrate 4 heat generating components 5, 50, 51 coming from the Electronic Integrated Circuit (EIC) 2 and from the photonic-integrated circuit (PIC) 3 (for instance Wafer level flip chipping of EIC, TEIC), and depositing thermal interfaces (TIM) 71, 72 on the heat generating components 5, thus forming an integrated PICs and EICs wafer 400; a wafer-level-testing may be advantageously realized after the deposition steps;
- etching and/or cutting a lidding wafer 600 supported on a carrier 601, for example, using a diamond saw;
- positioning the lidding wafer 600 on the substrate 4 of the integrated PICs and EICs wafer 400, thus defining a lidded cavity 63 in which the heat generating components 5, 50, 51 and thermal interfaces (TIM) 71, 72 are encapsulated;
- bonding the lidding wafer 600 on the substrate 4 and removing the carrier 601, for forming a lid 6, and singulating lidded PIC chips, e.g., by mechanical/laser dicing.

The lidding wafer (600) on the substrate (4) may be bonded by means of an adhesive, or by means of an eutectic alloy bonding, or by means of a hydrophilic bond obtained by direct wafer bonding of the lid (6) to the substrate (4), or by means of silica interface obtained by laser welding of the lid (6) to the substrate.

In order to realize an apparatus according to the embodiments illustrated by figures 6 to 9, the method of fabrication may further comprise, within a predefined zone B of the substrate located inside the lid bond line 60 and beneath the electrical inputs/outputs 20 and an electrical line 22 linking the heat generating components 5, 50, 51:
- a step of etching the thin layer of silicon 41, followed by
- a step of regrowth of a layer of silica 42, the remaining zone A inside the lid bond line 60 being positioned at least beneath said active photonic device 51.

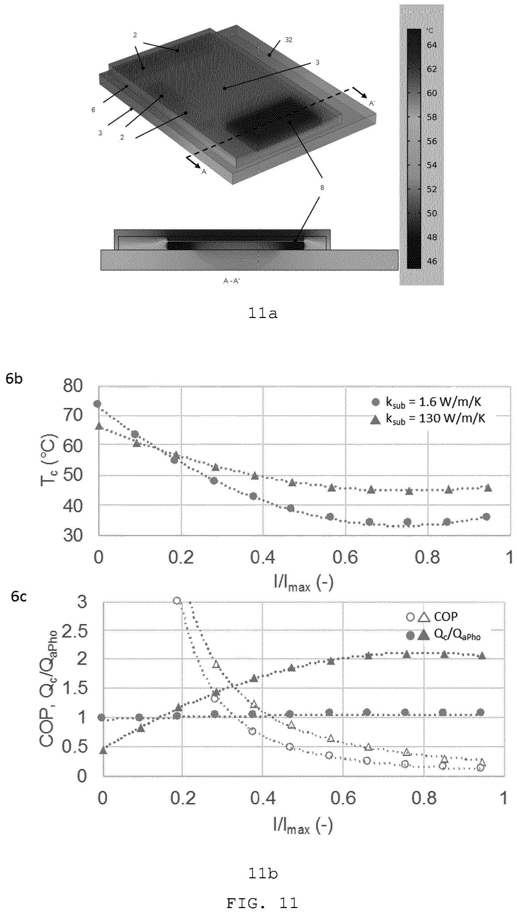

To demonstrate the advantage of the SOG substrate 4 in the densely integrated optoelectronics use case, 3D numerical simulations have been performed using the apparatus shown in FIG. 3 as a model (with a chip size of ~15 x 15 mm). FIG. 11 shows summary results of the simulated optoelectronic platform. The model (FIG. 11a) considers several flip-chipped electronics chips (drivers, TIAs) and an array of 11 lasers cooled by a low-profile TEM module. Heat generated by the components is removed by imposing a heat transfer coefficient boundary condition on the surface of a silicon lid encasing the components on the substrate, which is either standard SOI or SOG. TEM cold-side temperatures (FIG. 11b) suitable for laser operation (T_{c} ~ 50 °C) were achieved for a TEM input current of 0.38lₘₐₓ and 0.25lₘₐₓ for the SOI and SOG substrates, respectively. Referring to 7c, at this driving current the SOI substrate results in significant parasitic heat loading, Q_{c}/Q_{aPho} ~ 1.65, on the TEM from the electronic components not targeted for cooling due to the large thermal conductivity of the silicon handle of the SOI substrate. However, in the case of the SOG substrate, Q_{c}/Q_{aPho} ~ 1, indicating that the SOG substrate can provide excellent thermal isolation in small-scale integrated optoelectronic devices. The impact of reduced parasitics on TEM performance is significant. From the COP (= Q_{c}/W) and Q_{c}/Q_{aPho} plotted in FIG. 7c, we can determine the ratio of TEM power input (W) to the power dissipated by the active photonics targeted for cooling (Q_{aPho}). We can determine a ~50% reduction in TEM power requirements to achieve the laser cooling target on the SOG substrate compared to the SOI substrate. This corresponds to an overall power reduction for the modelled optoelectronic system of ~30%.

## Claims

1. An apparatus (1) integrating an Electronic Integrated Circuit (2), EIC, and a photonic-integrated circuit (3), PIC, wherein the PIC is an EIC-integrated PIC, said apparatus (1) comprising:
• a substrate (4) made of silicon on glass, SOG, which comprises integrated electrical inputs/outputs (20) and optical inputs/outputs (30) and passive optical components (31) of the PIC (3), being formed in the silicon of the SOG, wherein said substrate (4) comprises a layer of glass (40) on which is positioned a regrown layer of silica within a predefined zone (B) of the substrate and outside said predefined zone a thin layer of silicon (41) is positioned on top of said substrate;
• heat generating components (50, 51) comprising an active photonic device (51) from the PIC and an electric or electronic component (50) from the EIC, wherein said active photonic device (51) is situated on top of the substrate (4) and coupled to the electric or electronic component (50) disposed on the substrate (4) by an electrical line (22) on the substrate (4);
• a lid (6) comprising a top wall (61) forming a thermal plane for heatsink attachment and a side wall (62) being in contact with the substrate (4) and thus forming a lid bond line (60) on said substrate (4), said top wall (61) comprising an upper surface and a lower surface, said lid (6) defining a lidded cavity (63) comprised between the top wall (61), the side wall (62) and the substrate (4), said lid (6) being disposed on the substrate (4) such that the optical inputs/outputs (30) of the PIC (3) and the electrical inputs/outputs (20) are outside the lidded cavity (63) and said at least one heat generating component (5, 50, 51) is encapsulated within the lidded cavity (63),
• a first thermal interface (71), TIM, for thermally coupling the electric or electronic component (50) to said lid (6), said first thermal interface (71), TIM, being both in contact with the surface of the electric or electronic component (50) which is opposite the substrate (4) and with the lower surface of the top wall (61) of said lid (6);
• a second thermal interface (73), STIM, being situated on the surface of said active photonic device (5, 51) that is opposite the substrate (4);
• a micro-thermoelectric module (8), µTEM, for temperature controlling the active photonic device (51) and situated on the surface of the second thermal interface , STIM (73);
• a third thermal interface, TIM (72) for thermally coupling the micro-thermoelectric module, µTEM to the lid (6), the third thermal interface (72) being both in contact with the said micro-thermoelectric module (8) and with the lower surface of the top wall (61) of said lid (6);
wherein the predefined zone (B) of the substrate (4) is located inside the lid bond line (50) and beneath said electrical inputs/outputs (20) and said electrical line (22), the remaining zone (A) inside the lid bond line being positioned at least beneath said active photonic device (51).

2. The apparatus (1) according to claim 1, wherein the lid (6) is bonded to the substrate (4) by a heat-free bonding mechanism.

3. The apparatus (1) according to claim 1, wherein the lid (6) is bonded to the substrate by means of an adhesive, or by means of an eutectic alloy bonding, or by means of a hydrophilic bond obtained by direct wafer bonding of the lid (6) to the substrate (4), or by means of silica interface obtained by laser welding of the lid (6) to the substrate (4).

4. The apparatus (1) according to any of claims 1 to 3, wherein the first thermal interface (71), TIM, is selected from among gap pad filler materials, thermal greases, phase-change materials, graphite/carbon-backside materials.

5. The apparatus (1) according to claim 1, wherein the upper surface of the top wall (61) of said lid (6) is provided with an array of heat-dissipating fins (64) covering the heat generating components (50, 51).

6. The apparatus (1) according to claim 5, wherein said array of heat-dissipating fins (64) cover both the active photonic device (51) and the electric or electronic component (50) from the EIC.

7. The apparatus (1) according to claim 5, wherein said array of heat-dissipating fins (64) cover the electric or electronic component (50) from the EIC, while a second micro-thermoelectric module (82), µTEM, for temperature controlling said active photonic device (51) is situated on the upper surface of the top wall (61) of said lid (6) above said active photonic device (51).

8. The apparatus (1) according to any of claims 6 and 7, further comprising two arrays of thermally conductive vias (10) traversing the lid (6) for mitigating parasitic heat from the non-temperature-controlled components of the EIC (2) and from the components of the PIC (3).

9. The apparatus (1) according to claim 1, wherein said lid (6) is made of silicon, metal or ceramic.

10. The apparatus (1) according to claim 1, wherein the electrical inputs/outputs (20) are comprised in an electrical I/O plane formed on said regrown layer of silica (42) and linked to the EIC (2).

11. Method of fabrication of an apparatus (1) integrating an Electronic Integrated Circuit (2), EIC, and a photonic-integrated circuit (3), PIC, wherein the PIC is an EIC-integrated PIC, said EIC (2) including an electric or electronic component (50), said PIC (3) comprising an active photonic device (51), wherein the electric or electronic component (50) and active photonic device (51) are heat generating components, the apparatus further comprising a micro-thermoelectric module (8), µTEM, for temperature controlling the active photonic device (51), said method comprising:
• providing a substrate (4) made of silicon on a glass, SOG, comprising integrated electrical inputs/outputs (20) and optical inputs/outputs (30) and forming passive optical components (31) of the PIC (3) in the silicon of the SOG, wherein said substrate (4) comprises a layer of glass (40) on which is positioned a thin layer of silicon (41);
• etching the thin layer of silicon (41) within a predefined zone (B) of the substrate (4) excluding a remaining zone (A), wherein the predefined zone (B) is located beneath said electrical inputs/outputs (20) and an electrical line (22) adapted to ensure linkage of the electric or electronic component (50) and the active photonic device (51),
• regrowth of a layer of silica (42) in the predefined zone (B) of the substrate (4),
• depositing on the substrate (4) the electric or electronic component (50) and the active photonic device (51)
• depositing a first thermal interface (71), TIM, on the electric or electronic component (50), thus forming an integrated PICs and EICs wafer (400);
• depositing a second thermal interface (73), TIM, on the active photonic device (51) of the photonic-integrated circuit (3), thus forming an integrated PICs wafer (400);
• depositing the micro-thermoelectric module (8) on the surface of the second thermal interface (73);
• etching and/or cutting a lidding wafer (600) supported on a carrier (601);
• positioning the lidding wafer (600) on the substrate (4) of the integrated PICs and EICs wafer (400), thus defining a lidded cavity (63) in which the heat generating components (5, 50, 51) and thermal interfaces (71, 72) are encapsulated;
• bonding the lidding wafer (600) on the substrate (4) and removing the carrier, for forming a lid (6), said lid comprising a top wall (61) forming a thermal plane for heatsink attachment and a side wall (62) being in contact with the substrate (4) and thus forming a lid bond line (60) on said substrate (4),
wherein the predefined zone (B) and remaining zone (A) are located inside the lid bond line (60), wherein the remaining zone (A) is positioned at least beneath the active photonic device (51), wherein the top wall (61) of the lid comprises an upper surface and a lower surface, said lower surface contacting the first thermal interface (71).

12. Method of fabrication according to claim 11, wherein the bonding of the lidding wafer (600) on the substrate (4) is realized by means of an adhesive, or by means of an eutectic alloy bonding, or by means of a hydrophilic bond obtained by direct wafer bonding of the lid (6) to the substrate (4), or by means of silica interface obtained by laser welding of the lid (6) to the substrate (4).

13. Method of fabrication according to any of claims 11 and 12, further comprising depositing a third thermal interface (72), TIM, on the micro-thermoelectric module (8) after depositing the micro-thermoelectric module (8) on the surface of the second thermal interface (73), the lower surface of the top wall (61) of the lid contacting the third thermal interface (72).

## Patentansprüche

1. Vorrichtung (1), die eine elektronische integrierte Schaltung (2), EIC, und eine photonische integrierte Schaltung (3), PIC, integriert, wobei die PIC eine EIC-integrierte PIC ist, wobei die Vorrichtung (1) umfasst:
• ein Substrat (4), das aus Silizium auf Glas, SOG, besteht und das integrierte elektrische Eingänge/Ausgänge (20) und optische Eingänge/Ausgänge (30) und passive optische Bauteile (31) der PIC (3) umfasst, die in dem Silizium des SOG gebildet sind, wobei das Substrat (4) eine Schicht aus Glas (40) umfasst, auf der eine neu gezüchtete Schicht aus Siliziumdioxid innerhalb einer vordefinierten Zone (B) des Substrats positioniert ist, und außerhalb der vordefinierten Zone eine dünne Schicht aus Silizium (41) auf dem Substrat positioniert ist;
• wärmeerzeugende Bauteile (50, 51), die eine aktive photonische Vorrichtung (51) von der PIC und ein elektrisches oder elektronisches Bauteil (50) von der EIC umfassen, wobei die aktive photonische Vorrichtung (51) sich auf dem Substrat (4) befindet und an das elektrische oder elektronische Bauteil (50), das auf dem Substrat (4) angeordnet ist, durch eine elektrische Leitung (22) auf dem Substrat (4) gekoppelt ist;
• einen Deckel (6), der eine obere Wand (61), die eine thermische Ebene zur Wärmesenkenanbringung bildet, und eine Seitenwand (62) umfasst, die mit dem Substrat (4) in Kontakt steht und somit eine Deckel-Bond-Linie (60) auf dem Substrat (4) bildet, wobei die obere Wand (61) eine obere Oberfläche und eine untere Oberfläche umfasst, der Deckel (6) einen Hohlraum (63) mit Deckel definiert, der zwischen der oberen Wand (61), der Seitenwand (62) und dem Substrat (4) enthalten ist, wobei der Deckel (6) derart auf dem Substrat (4) angeordnet ist, dass die optischen Eingänge/Ausgänge (30) der PIC (3) und die elektrischen Eingänge/Ausgänge (20) sich außerhalb des Hohlraums (63) mit Deckel befinden und das mindestens eine wärmeerzeugende Bauteil (5, 50, 51) innerhalb des Hohlraums (63) mit Deckel eingekapselt ist,
• eine erste thermische Grenzfläche (71), TIM, zum thermischen Koppeln des elektrischen oder elektronischen Bauteils (50) an den Deckel (6), wobei die erste thermische Grenzfläche (71), TIM, sowohl mit der Oberfläche des elektrischen oder elektronischen Bauteils (50), die dem Substrat (4) entgegengesetzt ist, als auch mit der unteren Unterfläche der oberen Wand (61) des Deckels (6) in Kontakt steht;
• eine zweite thermische Grenzfläche (73), STIM, die sich auf der Oberfläche der aktiven photonischen Vorrichtung (5, 51) befindet, die dem Substrat (4) entgegengesetzt ist;
• ein mikrothermoelektrisches Modul (8), µTEM, zur Temperaturregelung der aktiven photonischen Vorrichtung (51) und die sich auf der Oberfläche der zweiten thermischen Grenzfläche, STIM, (73) befindet;
• eine dritte thermische Grenzfläche, TIM, (72) zum thermischen Koppeln des mikrothermoelektrischen Moduls, µTEM, an den Deckel (6), wobei die dritte thermische Grenzfläche (72) sowohl mit dem mikrothermoelektrischen Modul (8) als auch mit der unteren Oberfläche der oberen Wand (61) des Deckels (6) in Kontakt steht;
wobei die vordefinierte Zone (B) des Substrats (4) sich innerhalb der Deckel-Bond-Linie (50) und unterhalb der elektrischen Eingänge/Ausgänge (20) und der elektrischen Leitung (22) befindet, wobei die verbleibende Zone (A) innerhalb der Deckel-Bond-Linie mindestens unter der aktiven photonischen Vorrichtung (51) positioniert ist.

2. Vorrichtung (1) nach Anspruch 1, wobei der Deckel (6) durch einen wärmefreien Bonding-Mechanismus an das Substrat (4) gebondet ist.

3. Vorrichtung (1) nach Anspruch 1, wobei der Deckel (6) mittels eines Haftmittels oder mittels eines Bondens mit eutektischer Legierung oder mittels einer hydrophilen Bindung, die mittels direkten Wafer-Bondens des Deckels (6) an das Substrat (4) erhalten wird, oder mittels einer Siliziumdioxid-Grenzfläche, die mittels Laserschweißens des Deckels (6) an das Substrat (4) erhalten wird, an das Substrat gebondet ist.

4. Vorrichtung (1) nach einem der Ansprüche 1 bis 3, wobei die erste thermische Grenzfläche (71), TIM, aus Gap-Pad-Füllmaterialien, Wärmeleitpasten, Phasenwechselmaterialien, Graphit/Kohlenstoff-Rückseitenmaterialien ausgewählt ist.

5. Vorrichtung (1) nach Anspruch 1, wobei die obere Oberfläche der oberen Wand (61) des Deckels (6) mit einem Array von wärmeableitenden Rippen (64) versehen ist, welche die wärmeerzeugenden Bauteile (50, 51) bedecken.

6. Vorrichtung (1) nach Anspruch 5, wobei das Array von wärmeableitenden Rippen (64) sowohl die aktive photonische Vorrichtung (51) als auch das elektrische oder elektronische Bauteil (50) von der EIC bedeckt.

7. Vorrichtung (1) nach Anspruch 5, wobei das Array von wärmeableitenden Rippen (64) das elektrische oder elektronische Bauteil (50) von der EIC bedeckt, während ein zweites mikrothermoelektrisches Modul (82), µTEM, zur Temperaturregelung der aktiven photonischen Vorrichtung (51) sich auf der oberen Oberfläche der oberen Wand (61) des Deckels (6) über der aktiven photonischen Vorrichtung (51) befindet.

8. Vorrichtung (1) nach einem der Ansprüche 6 und 7, ferner umfassend zwei Arrays von thermisch leitfähigen Durchkontaktierungen (10), die den Deckel (6) durchqueren, zur Minderung parasitärer Wärme von den nicht temperaturgeregelten Bauteilen der EIC (2) und von den Bauteilen der PIC (3).

9. Vorrichtung (1) nach Anspruch 1, wobei der Deckel (6) aus Silizium, Metall oder Keramik besteht.

10. Vorrichtung (1) nach Anspruch 1, wobei die elektrischen Eingänge/Ausgänge (20) in einer elektrischen E/A-Ebene enthalten sind, die auf der neu gezüchteten Schicht aus Siliziumdioxid (42) gebildet ist und mit der EIC (2) verbunden ist.

11. Verfahren zur Herstellung einer Vorrichtung (1), die eine elektronische integrierte Schaltung (2), EIC, und eine photonische integrierte Schaltung (3), PIC, integriert, wobei die PIC eine EIC-integrierte PIC ist, wobei die EIC (2) ein elektrisches oder elektronisches Bauteil (50) umfasst, die PIC (3) eine aktive photonische Vorrichtung (51) umfasst, wobei das elektrische oder elektronische Bauteil (50) und die aktive photonische Vorrichtung (51) wärmeerzeugende Bauteile sind, die Vorrichtung ferner ein mikrothermoelektrisches Modul (8), µTEM, zur Temperaturregelung der aktiven photonischen Vorrichtung (51) umfasst, wobei das Verfahren umfasst:
• Bereitstellen eines Substrats (4), das aus Silizium auf einem Glas, SOG, besteht und integrierte elektrische Eingänge/Ausgänge (20) und optische Eingänge/Ausgänge (30) umfasst, und Bilden passiver optischer Bauteile (31) der PIC (3) in dem Silizium des SOG, wobei das Substrat (4) eine Schicht aus Glas (40) umfasst, auf der eine dünne Schicht aus Silizium (41) positioniert ist;
• Ätzen der dünnen Schicht aus Silizium (41) mit einer vordefinierten Zone (B) des Substrats (4) außer einer verbleibenden Zone (A), wobei die vordefinierte Zone (B) sich unter den elektrischen Eingängen/Ausgängen (20) und einer elektrischen Leitung (22) befindet, die dazu gestaltet ist, Verbindung des elektrischen oder elektronischen Bauteils (50) und der aktiven photonischen Vorrichtung (51) zu gewährleisten,
• Neuzüchten einer Schicht aus Siliziumdioxid (42) in der vordefinierten Zone (B) des Substrats (4),
• Abscheiden, auf dem Substrat (4), des elektrischen oder elektronischen Bauteils (50) und der aktiven photonischen Vorrichtung (51),
• Abscheiden einer ersten thermischen Grenzfläche (71), TIM, auf dem elektrischen oder elektronischen Bauteil (50), wodurch ein Wafer (400) mit integrierten PICs und EICs gebildet wird;
• Abscheiden einer zweiten thermischen Grenzfläche (73), TIM, auf der aktiven photonischen Vorrichtung (51) der photonischen integrierten Schaltung (3), wodurch ein Wafer (400) mit integrierten PICs gebildet wird;
• Abscheiden des mikrothermoelektrischen Moduls (8) auf der Oberfläche der zweiten thermischen Grenzfläche (73);
• Ätzen und/oder Schneiden eines abdeckenden Wafers (600), der auf einem Träger (601) getragen wird;
• Positionieren des abdeckenden Wafers (600) auf dem Substrat (4) des Wafers (400) mit integrierten PICs und EICs, wodurch ein Hohlraum (63) mit Deckel definiert wird, in dem die wärmeerzeugenden Bauteile (5, 50, 51) und die thermischen Grenzflächen (71, 72) eingekapselt sind;
• Bonden des Wafers (600) mit Deckel an dem Substrat (4) und Entfernen des Trägers, zum Bilden eines Deckels (6), wobei der Deckel eine obere Wand (61), die eine thermische Ebene zur Wärmesenkenanbringung bildet, und eine Seitenwand (62) umfasst, die mit dem Substrat (4) in Kontakt steht und somit eine Deckel-Bond-Linie (60) auf dem Substrat (4) bildet,
wobei die vordefinierte Zone (B) und die verbleibende Zone (A) sich innerhalb der Deckel-Bond-Linie (60) befinden, wobei die verbleibende Zone (A) mindestens unterhalb der aktiven photonischen Vorrichtung (51) positioniert ist, wobei die obere Wand (61) des Deckels eine obere Oberfläche und eine untere Oberfläche umfasst, wobei die untere Oberfläche die erste thermische Grenzfläche (71) kontaktiert.

12. Herstellungsverfahren nach Anspruch 11, wobei das Bonden des deckelbildenden Wafers (600) an dem Substrat (4) mittels eines Haftmittels oder mittels eines Bondens mit eutektischer Legierung oder mittels einer hydrophilen Bindung, die mittels direkten Wafer-Bondens des Deckels (6) an das Substrat (4) erhalten wird, oder mittels einer Siliziumdioxid-Grenzfläche ausgeführt wird, die durch Laserschweißen des Deckels (6) an das Substrat (4) erhalten wird.

13. Herstellungsverfahren nach einem der Ansprüche 11 und 12, ferner umfassend das Abscheiden einer dritten thermischen Grenzfläche (72), TIM, auf dem mikrothermoelektrischen Modul (8) nach dem Abscheiden des mikrothermoelektrischen Moduls (8) auf der Oberfläche der zweiten thermischen Grenzfläche (73), wobei die untere Oberfläche der oberen Wand (61) des Deckels die dritte thermische Grenzfläche (72) kontaktiert.

## Revendications

1. Appareil (1) intégrant un circuit intégré électronique (2), CIE, et un circuit intégré photonique (3), CIP, dans lequel le CIP est un CIP intégrant un CIE, ledit appareil (1) comprenant :
• un substrat (4) fait en silicium sur verre, SOG (silicon on glass), qui comprend des entrées/sorties électriques (20) et des entrées/sorties optiques (30) intégrées et des composants optiques passifs (31) du CIP (3), formés dans le silicium du SOG, lequel substrat (4) comprend une couche de verre (40) sur laquelle est positionnée une couche, formée par recroissance, de silice à l'intérieur d'une zone prédéfinie (B) du substrat et, à l'extérieur de ladite zone prédéfinie, une couche mince de silicium (41) est positionnée sur le dessus dudit substrat ;
• des composants générateurs de chaleur (50, 51) comprenant un dispositif photonique actif (51) provenant du CIP et un composant électrique ou électronique (50) provenant du CIE, parmi lesquels ledit dispositif photonique actif (51) est situé sur le dessus du substrat (4) et est couplé au composant électrique ou électronique (50) disposé sur le substrat (4) par une ligne électrique (22) sur le substrat (4) ;
• un couvercle (6) comprenant une paroi de dessus (61) formant un plan thermique pour la fixation d'un dissipateur thermique et une paroi latérale (62) qui est en contact avec le substrat (4) en formant ainsi une ligne de collage de couvercle (60) sur ledit substrat (4), ladite paroi de dessus (61) comprenant une surface supérieure et une surface inférieure, ledit couvercle (6) définissant une cavité avec couvercle (63) comprise entre la paroi de dessus (61), la paroi latérale (62) et le substrat (4), ledit couvercle (6) étant disposé sur le substrat (4) de façon que les entrées/sorties optiques (30) du CIP et les entrées/sorties électriques (20) soient à l'extérieur de la cavité avec couvercle (63) et que ledit au moins un composant générateur de chaleur (5, 50, 51) soit encapsulé à l'intérieur de la cavité avec couvercle (63),
• une première interface thermique (71), TIM, pour coupler thermiquement le composant électrique ou électronique (50) audit couvercle (6), ladite première interface thermique (71), TIM, étant en contact à la fois avec la surface du composant électrique ou électronique (50) qui est à l'opposé du substrat (4) et avec la surface inférieure de la paroi de dessus (61) dudit couvercle (6) ;
• une deuxième interface thermique (73), STIM, qui est située sur la surface dudit dispositif photonique actif (5, 51) qui est à l'opposé du substrat (4) ;
• un micromodule thermoélectrique (8), µTEM, pour réguler en température le dispositif photonique actif (51), qui est situé sur la surface de la deuxième interface thermique (73), STIM ;
• une troisième interface thermique (72), TIM, pour coupler thermiquement le micromodule thermoélectrique, µTEM, au couvercle (6), la troisième interface thermique (72) étant en contact à la fois avec ledit micromodule thermoélectrique (8) et avec la surface inférieure de la paroi de dessus (61) dudit couvercle (6) ;
dans lequel la zone prédéfinie (B) du substrat (4) est située à l'intérieur de la ligne de collage de couvercle (50) et sous lesdites entrées/sorties électriques (20) et ladite ligne électrique (22), la zone restante (A) à l'intérieur de la ligne de collage de couvercle étant positionnée au moins sous ledit dispositif photonique actif (51).

2. Appareil (1) selon la revendication 1, dans lequel le couvercle (6) est collé au substrat (4) par un mécanisme de collage sans chaleur.

3. Appareil (1) selon la revendication 1, dans lequel le couvercle (6) est collé au substrat au moyen d'un adhésif, ou au moyen d'un collage par alliage eutectique, ou au moyen d'un collage hydrophile obtenu par collage direct de galettes direct du couvercle (6) au substrat (4), ou au moyen d'une interface de silice obtenue par soudage au laser du couvercle (6) au substrat (4).

4. Appareil (1) selon l'une quelconque des revendications 1 à 3, dans lequel la première interface thermique (71), TIM, est choisie parmi les matériaux de coussin de remplissage thermique, les graisses thermiques, les matériaux à changement de phase, les matériaux à envers en graphite/carbone.

5. Appareil (1) selon la revendication 1, dans lequel la surface supérieure de la paroi de dessus (61) dudit couvercle (6) est dotée d'un réseau d'ailettes de dissipation thermique (64) couvrant les composants générateurs de chaleur (50, 51).

6. Appareil (1) selon la revendication 5, dans lequel ledit réseau d'ailettes de dissipation thermique (64) couvre à la fois le dispositif photonique actif (51) et le composant électrique ou électronique (50) provenant du CIE.

7. Appareil (1) selon la revendication 5, dans lequel ledit réseau d'ailettes de dissipation thermique (64) couvre le composant électrique ou électronique (50) provenant du CIE, tandis qu'un deuxième micromodule thermoélectrique (82), µTEM, pour réguler en température ledit dispositif photonique actif (51), est situé sur la surface supérieure de la paroi de dessus (61) dudit couvercle (6) au-dessus dudit dispositif photonique actif (51).

8. Appareil (1) selon l'une quelconque des revendications 6 et 7, comprenant en outre deux réseaux de trous d'interconnexion thermiquement conducteurs (10) traversant le couvercle (6) pour atténuer la chaleur parasite provenant des composants non régulés en température du CIE (2) et provenant des composants du CIP (3).

9. Appareil (1) selon la revendication 1, dans lequel ledit couvercle (6) est fait en silicium, métal ou céramique.

10. Appareil (1) selon la revendication 1, dans lequel les entrées/sorties électriques (20) sont comprises dans un plan E/S électrique formé sur ladite couche formée par recroissance de silice (42) et lié au CIE (2).

11. Procédé de fabrication d'un appareil (1) intégrant un circuit intégré électronique (2), CIE, et un circuit intégré photonique (3), CIP, dans lequel le CIP est un CIP intégrant un CIE, ledit CIE (2) comprenant un composant électrique ou électronique (50), ledit CIP (3) comprenant un dispositif photonique actif (51), dans lequel le composant électrique ou électronique (50) et le dispositif photonique actif (51) sont des composants générateurs de chaleur, l'appareil comprenant en outre un micromodule thermoélectrique (8), µTEM, pour réguler en température le dispositif photonique actif (51), ledit procédé comprenant :
• la fourniture d'un substrat (4) fait en silicium sur verre, SOG (silicon on glass), qui comprend des entrées/sorties électriques (20) et des entrées/sorties optiques (30) intégrées et la formation de composants optiques passifs (31) sur le CIP (3) dans le silicium du SOG, lequel substrat (4) comprend une couche de verre (40) sur laquelle est positionnée une couche mince de silicium (41) ;
• la gravure de la couche mince de silicium (41) à l'intérieur d'une zone prédéfinie (B) du substrat (4) excluant une zone restante (A), laquelle zone prédéfinie (B) est située sous lesdites entrées/sorties électriques (20) et une ligne électrique (22) adaptée pour assurer la liaison du composant électrique ou électronique (50) et du dispositif photonique actif (51),
• la recroissance d'une couche de silice (42) dans la zone prédéfinie (B) du substrat (4),
• la déposition sur le substrat (4) du composant électrique ou électronique (50) et du dispositif photonique actif (51),
• la déposition d'une première interface thermique (71), TIM, sur le composant électrique ou électronique (50), ce qui forme ainsi une galette avec CIP et CIE intégrés (400) ;
• la déposition d'une deuxième interface thermique (73), TIM, sur le dispositif photonique actif (51) du circuit intégré photonique (3), ce qui forme ainsi une galette avec CIP intégrés (400) ;
• la déposition du micromodule thermoélectrique (8) sur la surface de la deuxième interface thermique (73) ;
• la gravure et/ou le découpage d'une galette formant couvercle (600) supportée sur un support (601) ;
• le positionnement de la galette formant couvercle (500) sur le substrat (4) de la galette avec CIP et CIE intégrés (400), ce qui définit ainsi une cavité avec couvercle (63) dans laquelle les composants générateurs de chaleur (5, 50, 51) et les interfaces thermiques (71, 72) sont encapsulés ;
• le collage de la galette formant couvercle (600) sur le substrat (4) et le retrait du support, pour former un couvercle (6), ledit couvercle comprenant une paroi de dessus (61) formant un plan thermique pour la fixation d'un dissipateur thermique et une paroi latérale (62) qui est en contact avec le substrat (4) en formant ainsi une ligne de collage de couvercle (60) sur ledit substrat (4),
dans lequel la zone prédéfinie (B) et la zone restante (A) sont situées à l'intérieur de la ligne de collage de couvercle (60), dans lequel la zone restante (A) est positionnée au moins sous le dispositif photonique actif (51), dans lequel la paroi de dessus (61) du couvercle comprend une surface supérieure et une surface inférieure, ladite surface inférieure venant au contact de la première interface thermique (71).

12. Procédé de fabrication selon la revendication 11, dans lequel le collage de la galette formant couvercle (600) sur le substrat (4) est effectué au moyen d'un adhésif, ou au moyen d'un collage par alliage eutectique, ou au moyen d'un collage hydrophile obtenu par collage de galettes direct du couvercle (6) au substrat (4), ou au moyen d'une interface de silice obtenue par soudage au laser du couvercle (6) au substrat (4).

13. Procédé de fabrication selon l'une quelconque des revendications 11 et 12, comprenant en outre la déposition d'une troisième interface thermique (72), TIM, sur le micromodule thermoélectrique (8) après la déposition du micromodule thermoélectrique (8) sur la surface de la deuxième interface thermique (73), la surface inférieure de la paroi de dessus (61) du couvercle venant au contact de la troisième interface thermique (72).
